# EUROPEAN PATENT APPLICATION

(11) **EP 4 585 648 A1**
(43) Date of publication of application: **16.07.2025**
(21) Application number: 23870493.6
(22) Date of filing: 19.09.2023
(51) Int. Cl.: C08L 77/06, C08K 3/22, C08K 3/30, H01L 33/60

(54) **POLYAMIDE MOLDING COMPOSITION, PREPARATION METHOD THEREFOR, AND USE THEREOF**

(30) Priority: 29.09.2022 CN 202211196046
(71) Applicant: ZHUHAI VANTEQUE SPECIALTY ENGINEERING PLASTICS CO., LTD., Guangdong 519050 (CN); KINGFA SCI. & TECH. CO., LTD., Guangzhou, Guangdong 510663 (CN)
(72) Inventor: YANG, Huixin, Zhuhai, Guangdong 519050 (CN); CHEN, Pingxu, Zhuhai, Guangdong 519050 (CN); YE, Nanbiao, Zhuhai, Guangdong 519050 (CN); MAI, Jiehong, Zhuhai, Guangdong 519050 (CN); JIANG, Sujun, Zhuhai, Guangdong 519050 (CN); LI, Jianwei, Zhuhai, Guangdong 519050 (CN); YAN, Kun, Zhuhai, Guangdong 519050 (CN); XU, Xianjun, Zhuhai, Guangdong 519050 (CN)
(74) Representative: Meyer, Thorsten
(86) International application number: PCT/CN2023/119818
(87) International publication number: WO 2024/067261

(57) **Abstract**

A polyamide molding composition is provided, including the following components in parts by weight: a PAXC/YC resin in 40 parts to 75 parts, a white pigment in 30 parts to 60 parts, and a dispersing agent in parts by weight that are 1.5% to 5% of the parts by weight of the white pigment; based on a molar percentage of the PAXC/YC, the PAXC/YC resin includes 60 mol% to 100 mol% of an XC unit and 0 mol% to 40 mol% of a YC unit; the XC unit consists of a 1,4-cyclohexanedicarboxylic acid unit and a diamine unit, and the diamine unit is at least one selected from the group consisting of a 1,9-nonanediamine unit, a 1,10-decanediamine unit, and a 1,12-dodecanediamine unit; the YC unit consists of a 1,4-cyclohexanedicarboxylic acid unit and a diamine unit, and the diamine unit is at least one selected from the group consisting of aliphatic diamine units with 5 to 13 carbon atoms. The white pigment is well dispersed in the polyamide molding composition of the present disclosure. Moreover, the polyamide molding composition can exhibit the advantages of high reflectivity and high melting point when the white pigment is added merely at a conventional amount.

## Description

### TECHNICAL FIELD

The present disclosure relates to the technical field of polymers, and in particular relates to a polyamide (PA) molding composition and a preparation method and use thereof.

### BACKGROUND

A light-emitting diode (LED) light source is mainly composed of a semiconductor chip, an LED reflector, a gold wire, and an encapsulant. An LED reflector serves as a skeleton for an LED light source, and is also a functional component. During an LED encapsulation process, die bonding, wire bonding, and encapsulant curing are required to integrate all materials and components. An LED reflector is designed to reflect light emitted by an LED chip at a specific angle to reduce an optical loss, and then the reflected light passes through an encapsulation material such as epoxy resin or silicone to form a light source for LED lighting or display. An LED reflector material is a core material for LED lighting, and is directly related to the performance and life span of an LED light source.

In the application fields of lighting sources and backlights, the brightness of a single lamp bead is a critical performance index for reducing the number of lamp beads to achieve the energy conservation and environmental protection. The light brightness of an individual lamp bead depends on a power of a chip and a reflectivity of an LED reflector. The larger the power of a chip, the higher the brightness of an individual LED lamp bead, accordingly, a higher melting point is required for an LED reflector. The higher the reflectivity of an LED reflector, the higher the brightness of an individual LED lamp bead. In the prior art, the surface whiteness can be improved by adding titanium dioxide at an ultra-high content (65 wt% or more) to enhance the light reflectivity. However, the ultra-high-content titanium dioxide will deteriorate the processability and easily leads to an uneven surface of an LED reflector, which may instead reduce the light reflectivity and increase the manufacturing difficulty.

The traditional LED reflector material is mainly a combination of a semi-aromatic high-temperature-resistant polyamide material, a reinforcing filler, and a white pigment. The semi-aromatic polyamide material includes unsaturated bonds of benzene rings. As a result, the semi-aromatic polyamide material is prone to yellowing under a high-power LED light source due to shearing and heat during processing, which affects the brightness of a material. In addition, in a material system filled with a white pigment at a high content, the dispersion of the white pigment affects the brightness of the material.

The Chinese patent CN102482492B discloses an LED reflector. In this Chinese patent, a polyamide including 80 mol% to 100 mol% of 1,4-cyclohexanedicarboxylic acid unit as a dicarboxylic acid unit and 50 mol% to 100 mol% of an aliphatic diamine unit with 4 to 18 carbon atoms as a diamine unit. After the LED reflector is placed at a position with an illuminance of 10 mW/cm² under a wavelength of 300 nm to 400 nm and irradiated with a light for 336 h at 120°C in the air (where the light is derived from a metal halide lamp and passes through a color filter transmitting light of 295 nm to 780 nm), the LED reflector has a reflectivity of 90% or more for light with a wavelength of 460 nm. However, LED reflectors applied to strong light sources need to have an improved reflectivity.

### SUMMARY

A polyamide (PA) molding composition is provided, including the following components in parts by weight:

| | |
|---|---|
| a PAXC/YC resin | 40 parts to 75 parts; |
| a white pigment | 30 parts to 60 parts; and |
| a dispersing agent | 1.5% to 5% of the parts by weight of the white pigment (i.e., 1.5wt% to 5wt% of the white pigment), |

where based on a molar percentage of the PAXC/YC, the PAXC/YC resin includes 60 mol% to 100 mol% of an XC unit and 0 mol% to 40 mol% of a YC unit; the XC unit consists of 1,4-cyclohexanedicarboxylic acid unit (C) and a diamine unit X, and the diamine unit X is at least one selected from the group consisting of a 1,9-nonanediamine unit, a 1,10-decanediamine unit, and a 1,12-dodecanediamine unit; the YC unit consists of a 1,4-cyclohexanedicarboxylic acid unit (C) and a diamine unit Y, and the diamine unit Y is at least one selected from the group consisting of aliphatic diamine units with 5 to 13 carbon atoms;

the dispersing agent is at least one selected from the group consisting of calcium oxide and zinc oxide;
an average particle size of the white pigment is 0.10 µm to 0.50 µm, and an average particle size of the dispersing agent is 1 µm to 6 µm; and
a dispersion coefficient α of the white pigment in the polyamide molding composition is measured by a three-dimensional X-ray microscope to be larger than 65%.

A polymerization method for the PAXC/YC resin is as follows: pre-polymerization: adding polymerization monomers (a diacid and a diamine), benzoic acid as a capping agent, and deionized water to a stainless-steel high-pressure reactor equipped with mechanical stirring; vacuuming, and conducting N₂ replacement three times; conducting a heating process under stirring, the heating process is as follows: heating at a heating rate of 4°C/min to 6°C/min to 170°C to 190°C, holding the temperature of 170°C to 190°C for 1 h to 2 h, heating at a heating rate of 1°C/min to 3 °C/min to 260°C to 280°C; holding the temperature of 260°C to 280°C for 3 h to 5 h under slow stirring, which allows the pre-polymerization reaction fully proceed; slowly heating to 270°C to 290°C, and discharging water until a pressure is reduced to an atmospheric pressure; and closing a water-discharge valve when the pressure is reduced to the atmospheric pressure, cooling to room temperature, and discharging a product. Solid-state polymerization: feeding the product prepared after the pre-polymerization into a vacuum rotating drum with a rotational speed of 10 r/min to 15 r/min and a vacuum degree of 25 Pa to 35 Pa; and heating at a heating rate of 15°C/min to 25°C/min to 260°C to 270°C, sampling for viscosity testing, and determining an end point of discharging according to a viscosity test result.

The aliphatic diamine with 5 to 13 carbon atoms is at least one selected from the group consisting of 1,5-pentanediamine, 1,6-hexanediamine, 1,7-heptanediamine, 1,8-octanediamine, 1,9-nonanediamine, 2-methyl-1,8-octanediamine, 1,10-decanediamine, 1,11-undecanediamine, 1,12-dodecanediamine, and 1,13-tridecanediamine; and preferably, the aliphatic diamine with 5 to 13 carbon atoms is selected from 2-methyl-1,8-octanediamine.

When a content of the XC unit is less than 60 mol%, a melting point of the PAXC/YC resin is lower than 320°C.

Preferably, when a content of the white pigment is 45 parts to 60 parts, a content of the dispersing agent is 3% to 4% of the parts by weight of the white pigment (i.e., 3wt% to 4wt% of the white pigment).

Preferably, based on the molar percentage of the PAXC/YC, the PAXC/YC resin includes 65 mol% to 90 mol% and preferably 70 mol% to 79.99 mol% of the XC unit.

Preferably, the average particle size of the white pigment is 0.15 µm to 0.35 µm, and preferably, the average particle size of the dispersing agent is 3 µm to 4 µm.

Preferably, when the white pigment is titanium dioxide, the dispersing agent is calcium oxide; and when the white pigment is zinc sulfide, the dispersing agent is zinc oxide.

A total reflectivity of the polyamide molding composition for red light with a wavelength of 650 nm, green light with a wavelength of 550 nm, and blue light with a wavelength of 450 nm is higher than 285%.

Preferably, the total reflectivity of the polyamide molding composition for the red light with the wavelength of 650 nm, the green light with the wavelength of 550 nm, and the blue light with the wavelength of 450 nm is higher than 290%.

The melting point of the PAXC/YC resin of the present disclosure is higher than 320°C.

A preparation method of the polyamide molding composition of the present disclosure is provided, including the following steps: thoroughly mixing the components in a mixer, and conducting extrusion granulation with a twin-screw extruder to produce the polyamide molding composition, where a screw has a temperature range of 280°C to 330°C and a rotational speed of 400 r/min to 500 r/min.

A use of the polyamide molding composition of the present disclosure in preparation of an LED reflector is provided. The polyamide molding composition is suitable for high-power LED reflectors.

The present disclosure has the following beneficial effects:
The present disclosure adopts a PAXC/YC resin with a high melting point, excellent resistance to yellowing, and resistance to high-power light sources and adopts a specified content of a dispersing agent to significantly promote the dispersion of a white pigment (titanium dioxide and zinc sulfide), such that the total reflectivity for red light with a wavelength of 650 nm, green light with a wavelength of 550 nm, and blue light with a wavelength of 450 nm can be significantly improved (indicating that the LED reflector can achieve a high light reflectivity). The present disclosure solves the defect that a powder can hardly be dispersed in a PAXC/YC resin due to a high viscosity of the PAXC/YC resin.

### DETAILED DESCRIPTION

The present disclosure is described in detail below with reference to specific embodiments. The following embodiments will help those skilled in the art to further understand the present disclosure, but do not limit the present disclosure in any way. It should be noted that those of ordinary skill in the art can further make several variations and improvements without departing from the idea of the present disclosure. These all fall within the protection scope of the present disclosure.

Raw materials adopted in the examples and comparative examples of the present disclosure are as follows:
PA10C/5C: an XC content is 70 mol%; X is 1,10-decanediamine and Y is 1,5-pentanediamine; it is homemade; and a melting point is 321°C.
PA10C/6C: an XC content is 70 mol%; X is 1,10-decanediamine and Y is 1,6-hexanediamine; it is homemade; and a melting point is 325°C.
PA10C/9C: an XC content is 70 mol%; X is 1,10-decanediamine and Y is 1,9-nonanediamine; it is homemade; and a melting point is 329°C.
PA10C/12C-A: an XC content is 60 mol%; X is 1,10-decanediamine and Y is 1,12-dodecanediamine; it is homemade; and a melting point is 320°C.
PA10C/12C-B: an XC content is 65 mol%; X is 1,10-decanediamine and Y is 1,12-dodecanediamine; it is homemade; and a melting point is 334°C.
PA10C/12C-C: an XC content is 70 mol%; X is 1,10-decanediamine and Y is 1,12-dodecanediamine; it is homemade; and a melting point is 326°C.
PA10C/12C-D: an XC content is 79.9 mol%; X is 1,10-decanediamine and Y is 1,12-dodecanediamine; it is homemade; and a melting point is 330°C.
PA10C/12C-E: an XC content is 90 mol%; X is 1,10-decanediamine and Y is 1,12-dodecanediamine; it is homemade; and a melting point is 340°C.
PA10C: it is homemade, and a melting point is 355°C.
PA10C/12C-F: an XC content is 50 mol%; X is 1,10-decanediamine and Y is 1,12-dodecanediamine; it is homemade; and a melting point is 313°C.
PA10C/M8C: an XC content is 70 mol%; X is 1,10-decanediamine and Y is 2-methyl-1,8-octanediamine; it is homemade; and a melting point is 325°C.
PA9C/5C: an XC content is 90 mol%; X is 1,9-nonanediamine and Y is 1,5-pentanediamine; it is homemade; and a melting point is 341°C.
PA9C/6C: an XC content is 95 mol%; X is 1,9-nonanediamine and Y is 1,6-hexanediamine; it is homemade; and a melting point is 346°C.
PA9C/M8C: an XC content is 70 mol%; X is 1,9-nonanediamine and Y is 2-methyl-1,8-octanediamine; it is homemade; and a melting point is 322°C.
PA9C/12C: an XC content is 65 mol%; X is 1,9-nonanediamine and Y is 1,12-dodecanediamine; it is homemade; and a melting point is 324°C.
PA9C: it is homemade, and a melting point is 350°C.
PA12C/5C: an XC content is 70 mol%; X is 1,12-dodecanediamine and Y is 1,5-pentanediamine; it is homemade; and a melting point is 327°C.
PA12C/6C: an XC content is 85 mol%; X is 1,12-dodecanediamine and Y is 1,6-hexanediamine; it is homemade; and a melting point is 331°C.
PA12C: it is homemade, and a melting point is 349°C.
PA10T: it is homemade; and a melting point is 316°C.
PA10T/66: it is homemade; and a melting point is 295°C.

Titanium dioxide is purchased from LB Group Co., Ltd. and then sieved to a required average particle size:
titanium dioxide A: an average particle size is 0.11 µm;
titanium dioxide B: an average particle size is 0.15 µm;
titanium dioxide C: an average particle size is 0.35 µm;
titanium dioxide D: an average particle size is 0.50 µm;
titanium dioxide E: an average particle size is 0.06 µm; and
titanium dioxide F: an average particle size is 0.65 µm.

Zinc sulfide: Sachtolith HD-S, which has an average particle size of 0.14 µm and is purchased from Sachtleben Chemie GmbH.

Calcium oxide is purchased from Zhuozhou Yourong New Material Technology Co., Ltd. and then sieved to a required average particle size:
calcium oxide A: an average particle size is 1.2 µm;
calcium oxide B: an average particle size is 3.1 µm;
calcium oxide C: an average particle size is 4.0 µm;
calcium oxide D: an average particle size is 5.9 µm;
calcium oxide E: an average particle size is 0.4 µm; and
calcium oxide F: an average particle size is 8.4 µm.

Zinc oxide: an average particle size is 0.5 µm.

A preparation method for polyamide molding compositions in the examples and comparative examples was as follows: the components were thoroughly mixed in a mixer, and extrusion granulation was conducted with a twin-screw extruder to produce a polyamide molding composition, where a screw had a temperature range of 280°C-310°C-320°C-300°C-300°C-300°C -300°C-300°C-300°C-310°C-320°C-330°C and a rotational speed of 400 r/min to 500 r/min.

Test methods:
(1) RGB light reflectivity: A polyamide molding composition was prepared into a test sheet with a length of 60 mm, a width of 60 mm, and a thickness of 1 mm through injection molding. A reflectivity of the test sheet for light with wavelengths of 450 nm, 550 nm, and 650 nm was measured by a Color Eye 7000A colorimeter: RGB light reflectivity F = Rf (450 nm) + Rf (550 nm) + Rf (650 nm).
(2) Evaluation for dispersion of a white pigment: A nanoVoxel 2000 three-dimensional X-ray microscope manufactured by Tianjin Sanying Precision Instruments Co., Ltd. was used to conduct imaging for material particles with a volume pixel resolution of 1.9 µm. White pigment particles of different particle sizes were screened and counted to obtain a dispersion coefficient α of a white pigment (a volume percentage of white pigment particles with a volume of less than 20,000 µm³ in total white pigment particles).

**Table 1 Component contents (parts by weight) and test results for the polyamide molding compositions in Examples 1 to 8**

| | Example 1 | Example 2 | Example 3 | Example 4 | Example 5 | Example 6 | Example 7 | Example 8 |
|---|---|---|---|---|---|---|---|---|
| PA10C/5C | 40 | 75 | 60 | 60 | 60 | 60 | 60 | 60 |
| Titanium dioxide A | 30 | 60 | 45 | 45 | 45 | 45 | | |
| Titanium dioxide B | | | | | | | 45 | |
| Titanium dioxide C | | | | | | | | 45 |
| Calcium oxide A | 0.45 | 3 | 1.35 | 1.8 | 0.68 | 2.25 | 1.35 | 1.35 |
| Reflectivity for 450 nm, % | 94.49 | 95.31 | 95.69 | 96.79 | 94.69 | 94.71 | 96.52 | 96.55 |
| Reflectivity for 550 nm, % | 95.60 | 96.52 | 96.90 | 97.00 | 95.90 | 96.68 | 97.83 | 97.76 |
| Reflectivity for 650 nm, % | 96.16 | 97.08 | 97.56 | 97.56 | 96.96 | 97.08 | 98.29 | 97.82 |
| Total reflectivity, % | 286.25 | 288.91 | 290.15 | 291.35 | 287.55 | 288.47 | 292.64 | 292.13 |
| Dispersion coefficient α, % | 69.66 | 90.87 | 82.38 | 87.91 | 72.12 | 91.76 | 84.11 | 84.50 |

It can be seen from Examples 1 to 6 that the increase in a content of calcium oxide leads to the increase of a dispersion coefficient of a polyamide molding composition. However, if the content of the dispersing agent is too high, the reflectivity will be reduced because of the poor reflection of calcium oxide although there is a high dispersion coefficient. Specifically, it can be known from Examples 3 to 6 that, when a content of the white pigment is 45 parts to 60 parts, a content of the dispersing agent is preferably 3% to 4% of the parts by weight of the white pigment.

**Table 2 Component contents (parts by weight) and test results for the polyamide molding compositions in Examples 9 to 15**

| | Example 9 | Example 10 | Example 11 | Example 12 | Example 13 | Example 14 | Example 15 |
|---|---|---|---|---|---|---|---|
| PA10C/5C | 60 | 60 | 60 | 60 | 60 | 60 | 60 |
| Titanium dioxide B | | 45 | | | | | |
| Titanium dioxide D | 45 | | | | 45 | 45 | 45 |
| Zinc sulfide | | | 45 | 45 | | | |
| Zinc oxide | | 1.35 | | 1.35 | | | |
| Calcium oxide A | 1.35 | | 1.35 | | | | |
| Calcium oxide B | | | | | 1.35 | | |
| Calcium oxide C | | | | | | 1.35 | |
| Calcium oxide D | | | | | | | 1.35 |
| Reflectivity for 450 nm, % | 95.89 | 96.53 | 96.13 | 95.89 | 96.46 | 96.03 | 95.51 |
| Reflectivity for 550 nm, % | 97.10 | 97.60 | 96.14 | 97.41 | 97.47 | 97.24 | 96.82 |
| Reflectivity for 650 nm, % | 97.66 | 98.05 | 97.90 | 97.94 | 97.53 | 97.80 | 97.68 |
| Total reflectivity, % | 290.65 | 292.18 | 290.17 | 291.24 | 291.46 | 291.07 | 290.01 |
| Dispersion coefficient α, % | 84.70 | 83.47 | 85.40 | 86.10 | 84.90 | 85.10 | 81.40 |

It can be seen from Examples 3, 7, 8, and 9 that, although a large particle size of titanium dioxide corresponds to a high dispersion coefficient, an average particle size of 0.15 µm to 0.35 µm is preferred, which corresponds to a high reflectivity.

According to Examples 7, 10, 11, and 12, when the white pigment is titanium dioxide, the selection of calcium oxide as the dispersing agent leads to excellent dispersibility. When the white pigment is zinc sulfide, the selection of zinc oxide as the dispersing agent leads to excellent dispersibility.

It can be seen from Examples 9 and 13 to 15 that, when the dispersing agent has the preferred particle size, the white pigment is well dispersed, and the reflectivity is also high.

**Table 3 Component contents (parts by weight) and test results for the polyamide molding compositions in Examples 16 to 23**

| | Exampl e 16 | Exampl e 17 | Example 18 | Example 19 | Example 20 | Example 21 | Example 22 | Examp le 23 |
|---|---|---|---|---|---|---|---|---|
| PA resin | PA10C/ 6C | PA10C/ 9C | PA10C/12 C-A | PA10C/12 C-B | PA10C/12 C-C | PA10C/12 C-D | PA10C/12 C-E | PA10C |
| PA content | 60 | 60 | 60 | 60 | 60 | 60 | 60 | 60 |
| Titanium dioxide A | 45 | 45 | 45 | 45 | 45 | 45 | 45 | 45 |
| Calcium oxide A | 1.35 | 1.35 | 1.35 | 1.35 | 1.35 | 1.35 | 1.35 | 1.35 |
| Reflectivit y for 450 nm, % | 95.80 | 95.81 | 94.09 | 95.36 | 96.49 | 95.78 | 94.90 | 94.53 |
| Reflectivit y for 550 nm, % | 96.91 | 96.92 | 95.60 | 96.57 | 96.70 | 97.08 | 96.42 | 95.76 |
| Reflectivit y for 650 nm, % | 97.67 | 97.69 | 96.27 | 97.24 | 97.16 | 97.65 | 97.13 | 96.68 |
| Total reflectivity, % | 290.38 | 290.42 | 285.96 | 289.17 | 290.35 | 290.51 | 288.45 | 286.97 |
| Dispersion coefficient α, % | 83.09 | 83.27 | 83.90 | 84.22 | 84.51 | 84.03 | 85.64 | 84.20 |

It can be seen from Examples 18 to 23 that a content of the XC unit is preferably 65 mol% to 90 mol% and more preferably 70 mol% to 79.99 mol%.

**Table 4 Component contents (parts by weight) and test results for the polyamide molding compositions in Examples 24 to 30**

| | Example 24 | Example 25 | Example 26 | Example 27 | Example 28 | Example 29 | Example 30 |
|---|---|---|---|---|---|---|---|
| PA resin | PA10C/M8C | PA9C/5C | PA9C/6C | PA9C/M8C | PA9C/12C | PA9C | PA12C/5C |
| PA content | 60 | 60 | 60 | 60 | 60 | 60 | 60 |
| Titanium dioxide A | 45 | 45 | 45 | 45 | 45 | 45 | 45 |
| Calcium oxide A | 1.35 | 1.35 | 1.35 | 1.35 | 1.35 | 1.35 | 1.35 |
| Reflectivity for 450 nm, % | 97.62 | 95.28 | 94.68 | 97.52 | 95.24 | 94.03 | 95.87 |
| Reflectivity for 550 nm, % | 98.07 | 96.49 | 95.49 | 98.03 | 95.75 | 94.89 | 96.78 |
| Reflectivity for 650 nm, % | 98.76 | 97.05 | 96.36 | 98.39 | 96.82 | 96.13 | 97.55 |
| Total reflectivity, % | 294.45 | 288.82 | 286.53 | 293.94 | 287.81 | 285.05 | 290.20 |
| Dispersion coefficient α, % | 85.44 | 82.30 | 83.00 | 86.45 | 83.70 | 84.21 | 82.70 |

It can be seen from Examples 24 to 32 that the aliphatic diamine with 5 to 13 carbon atoms is preferably 2-methyl-1,8-octanediamine.

**Table 5 Component contents (parts by weight) and test results for the polyamide molding compositions in Examples 31 and 32 and Comparative Examples 1 to 3**

| | Example 31 | Example 32 | Comparative Example 1 | Comparative Example 2 | Comparative Example 3 |
|---|---|---|---|---|---|
| PA resin | PA12C/6C | PA12C | PA10C/12C-F | PA10T | PA10T/66 |
| PA content | 60 | 60 | 60 | 60 | 60 |
| Titanium dioxide A | 45 | 45 | 45 | 45 | 45 |
| Calcium oxide A | 1.35 | 1.35 | 1.35 | 1.35 | 1.35 |
| Reflectivity for 450 nm, % | 95.59 | 94.33 | 92.24 | 93.01 | 93.42 |
| Reflectivity for 550 nm, % | 96.5 | 95.57 | 93.43 | 93.57 | 94.1 |
| Reflectivity for 650 nm, % | 97.16 | 96.21 | 94.1 | 93.99 | 94.77 |
| Total reflectivity, % | 289.25 | 286.11 | 279.77 | 280.57 | 282.29 |
| Dispersion coefficient α, % | 82.90 | 82.05 | 58.44 | 63.42 | 61.70 |

According to Comparative Examples 1 to 3, the dispersivity of the white pigment of the present disclosure is critically affected by the resin matrix. The selection of other types of resin matrices will reduce the dispersion of the white pigment, and result in low reflectivity.

**Table 6 Component contents (parts by weight) and test results for the polyamide molding compositions in Comparative Examples 4 to 11**

| | Comparati ve Example 4 | Comparati ve Example 5 | Comparati ve Example 6 | Comparati ve Example 7 | Comparati ve Example 8 | Comparati ve Example 9 | Comparati ve Example 10 | Comparati ve Example 11 |
|---|---|---|---|---|---|---|---|---|
| PA10C/5C | 60 | 60 | 60 | 60 | 60 | 60 | 60 | 60 |
| Titanium dioxide A | 45 | 45 | | | 45 | 45 | 45 | 45 |
| Titanium dioxide E | | | 45 | | | | | |
| Titanium dioxide F | | | | 45 | | | | |
| Calcium oxide A | | | 1.35 | 1.35 | 0.45 | 2.7 | | |
| Calcium oxide E | 1.35 | | | | | | | |
| Calcium oxide F | | 1.35 | | | | | | |
| Zinc oxide | | | | | | | 0.45 | 2.7 |
| Reflectivity for 450 nm, % | 93.41 | 93.62 | 93.66 | 93.34 | 93.13 | 93.01 | 92.89 | 92.76 |
| Reflectivity for 550 nm, % | 94.62 | 94.83 | 94.87 | 94.55 | 94.34 | 94.22 | 94.10 | 93.97 |
| Reflectivity for 650 nm, % | 95.18 | 95.39 | 95.43 | 95.11 | 94.90 | 94.78 | 94.67 | 94.54 |
| Total reflectivity, % | 283.21 | 283.84 | 283.96 | 283.00 | 282.37 | 282.01 | 281.66 | 281.27 |
| Dispersion coefficient α, % | 64.70 | 63.50 | 63.53 | 63.31 | 63.17 | 63.09 | 63.01 | 62.92 |

It can be seen from Comparative Examples 4 and 5 that a too-large or too-small particle size of calcium oxide will significantly affect the dispersion coefficient of the white pigment, and reduce the reflectivity.

It can be seen from Comparative Examples 6 and 7 that a too-large or too-small particle size of titanium dioxide will significantly reduce the dispersion coefficient, and reduce the reflectivity.

It can be seen from Comparative Examples 8 to 11 that a too-low or too-high content of the dispersing agent will significantly reduce the dispersion coefficient, and reduce the reflectivity.

## Claims

1. A polyamide molding composition, comprising the following components in parts by weight:
| | |
|---|---|
| a PAXC/YC resin | 40 parts to 75 parts; |
| a white pigment | 30 parts to 60 parts; and |
| a dispersing agent | 1.5% to 5% of the parts by weight of the white pigment, |
wherein based on a molar percentage of the PAXC/YC, the PAXC/YC resin comprises 60 mol% to 100 mol% of an XC unit and 0 mol% to 40 mol% of a YC unit; the XC unit consists of a 1,4-cyclohexanedicarboxylic acid unit and a diamine unit X, and the diamine unit X is at least one selected from the group consisting of a 1,9-nonanediamine unit, a 1,10-decanediamine unit, and a 1,12-dodecanediamine unit; the YC unit consists of a 1,4-cyclohexanedicarboxylic acid unit and a diamine unit Y, and the diamine unit Y is at least one selected from the group consisting of aliphatic diamine units with 5 to 13 carbon atoms;
the dispersing agent is at least one selected from the group consisting of calcium oxide and zinc oxide;
an average particle size of the white pigment is 0.10 µm to 0.50 µm, and an average particle size of the dispersing agent is 1 µm to 6 µm; and
a dispersion coefficient α of the white pigment in the polyamide molding composition is measured by a three-dimensional X-ray microscope to be larger than 65%.

2. The polyamide molding composition according to claim 1, wherein the aliphatic diamine with 5 to 13 carbon atoms is at least one selected from the group consisting of 1,5-pentanediamine, 1,6-hexanediamine, 1,7-heptanediamine, 1,8-octanediamine, 1,9-nonanediamine, 2-methyl-1,8-octanediamine, 1,10-decanediamine, 1,11-undecanediamine, 1,12-dodecanediamine, and 1,13-tridecanediamine; and preferably, the aliphatic diamine with 5 to 13 carbon atoms is selected from 2-methyl-1,8-octanediamine.

3. The polyamide molding composition according to claim 1, wherein when a content of the white pigment is 45 parts to 60 parts, a content of the dispersing agent is 3% to 4% of the parts by weight of the white pigment.

4. The polyamide molding composition according to claim 1, wherein based on the molar percentage of the PAXC/YC, the PAXC/YC resin comprises 65 mol% to 90 mol% and preferably 70 mol% to 79.99 mol% of the XC unit.

5. The polyamide molding composition according to claim 1, wherein the average particle size of the white pigment is 0.15 µm to 0.35 µm, and the average particle size of the dispersing agent is 3 µm to 4 µm.

6. The polyamide molding composition according to claim 1, wherein when the white pigment is titanium dioxide, the dispersing agent is calcium oxide; and when the white pigment is zinc sulfide, the dispersing agent is zinc oxide.

7. The polyamide molding composition according to any one of claims 3-6, wherein a total reflectivity of the polyamide molding composition for red light with a wavelength of 650 nm, green light with a wavelength of 550 nm, and blue light with a wavelength of 450 nm is higher than 285%; and preferably, the total reflectivity of the polyamide molding composition for the red light with the wavelength of 650 nm, the green light with the wavelength of 550 nm, and the blue light with the wavelength of 450 nm is higher than 290%.

8. The polyamide molding composition according to claim 1, wherein a melting point of the PAXC/YC resin is higher than 320°C.

9. A preparation method of the polyamide molding composition according to any one of claims 1-8, comprising the following steps: thoroughly mixing the components in a mixer, and conducting extrusion granulation with a twin-screw extruder to produce the polyamide molding composition, wherein a screw has a temperature range of 280°C to 330°C and a rotational speed of 400 r/min to 500 r/min.

10. Use of the polyamide molding composition according to any one of claims 1-8 in the preparation of a light-emitting diode (LED) reflector.
